# EUROPEAN PATENT APPLICATION

(11) **EP 4 745 829 A1**
(43) Date of publication of application: **20.05.2026**
(21) Application number: 24213414.6
(22) Date of filing: 15.11.2024
(51) Int. Cl.: G06F 30/33, G06F 30/367, G06F 30/398

(54) **OPTICAL PATH TRACING IN A DESIGN OF AN INTEGRATED CIRCUIT**

(71) Applicant: Luceda NV, 9000 Gent (BE)
(72) Inventor: Van Vrekhem, Dennis, 9520 Sint-Lievens-Houtem (BE); Fiers, Martin André Agnes, 9270 Laarne (BE)
(74) Representative: Ipsilon Belgium

(57) **Abstract**

A computer-implemented method for determining an optical path (60) for an optical signal (2) in a design (1) of an integrated circuit, comprising:
- receiving a design (1) comprising:
∘ a plurality of devices (100) with ports (10);
∘ one or more nets (200) coupling ports (10) of devices (100);

- for each of the devices (100), receiving a binary device matrix (40) indicating between which ports (10) the optical signal (2) can propagate;
- selecting a first port (11);
- selecting a second port (12); and
- determining one or more optical paths (60) from the first port (11) to the second port (12) in function of the nets (200) and in function of the binary device matrices (40) of each of the devices (100) comprised between the first port (11) and the second port (12).

## Description

### Technical Field

The present invention generally relates, amongst others, to a computer-implemented method and a system for electronic design automation, also referred to as EDA. More particularly, it relates to a computer-implemented method and a system for operating on and/or editing a computer-implemented design of an integrated circuit, preferably within the framework of software for the design of photonic integrated circuits.

### Background

Electronic design automation, EDA, also referred to as electronic computer-aided design or ECAD, refers to a category of software tools or computer-implemented tools for designing electronic systems such as for example integrated circuits, also referred to as ICs, and/or printed circuit boards, also referred to as PCBs. A design of an IC typically comprises one or more devices, such as for example one or more electronic devices and/or one or more photonic devices. Each device is typically characterized by one or more ports through which the device may for example communicate with other devices of the design and/or for example may receive and/or transmit signals and/or at least partially isolate the device.

A workflow of a designer of for example a photonic IC usually comprises the following steps. The designer starts encoding the circuit layout of the devices of the IC, for example in Python or in any other suitable programming language. The circuit layout is to be understood as comprising a topology of the IC. A schematic is for example an abstract representation of the circuit layout of a photonic IC. Schematic Driven Layout, also referred to as SDL, can be used to generate a physical layout of an IC from one or more schematics. A schematic of the photonic IC is then the 'master' and the physical layout is implemented based on the schematic by adding placement of the devices and routing information between the devices. The designer can for example bring information from the layout into the schematic by using back annotations for verification. On the other hand, Layout Versus Schematic, also referred to as LVS, is the class of electronic design automation verification software that determines whether a particular physical layout of an IC corresponds to the original schematic or circuit diagram of the design. LVS can for example be used to generate a schematic of the IC by extracting the schematic from the physical layout.

Circuit simulations may also be ran by a designer to verify a functionality of each device and the whole functionality of the design. In the electronics domain, net tracing allows to graphically display end to end connections between devices comprised in a design of an IC or PCB. In the optical domain, circuit simulations can be ran to determine one or more parameters of an optical signal propagating for example from a port of a device or entering another device at another port. The results of the circuit simulations may be used to improve the generated schematics of the layout. Once the design complies with the requirements of the designer, a final layout is generated for production of the physical layout of the IC in for example a foundry.

### Summary

In the optical domain, it remains challenging to determine how an optical signal propagates through a design comprising a plurality of devices. In other words, it remains challenging to determine or simulate how light would physically propagate in a design of a photonic IC, especially in a complex circuit, if the photonic IC were to be physically manufactured.

It is thus an object of embodiments of the present invention to propose a computer-implemented method and a system which do not show the inherent shortcomings of the prior art. More specifically, it is an object of embodiments of the present invention to propose a computer-implemented method and a system to determine or simulate how an optical signal propagates in a design of a photonic IC.

The scope of protection sought for various embodiments of the invention is set out by the independent claims.

The embodiments and features described in this specification that do not fall within the scope of the independent claims, if any, are to be interpreted as examples useful for understanding various embodiments of the invention.

There is a need for a computer-implemented method which gives more insight to a designer of for example a photonic IC on how light would be physically travelling in a design of a photonic IC if the photonic IC were to be physically manufactured. This way, if the design is finalized, a designer of the photonic IC can anticipate how light will travel through the design once the photonic IC is physically manufactured.

Amongst others, it is an object of embodiments of the invention to enable a computer-implemented method to determine how an optical signal propagates or flows or travels between any two ports of a design of a photonic IC.

Amongst others, it is an object of embodiments of the invention to enable a computer-implemented method to graphically display how light would propagate or flow or travel between any two ports of a design of a photonic IC if the photonic IC were to be manufactured.

This object is achieved, according to a first example aspect of the present disclosure, by a computer-implemented method for determining one or more optical paths along which an optical signal propagates in a design of an integrated circuit, the method comprising the steps of:
- receiving a design of an integrated circuit comprising:
   ∘ a plurality of devices, each of the devices comprising ports;
   ∘ one or more nets, wherein each net couples one of the ports of one of the devices to one of the ports of another one of the devices;
- for each of the devices, receiving a binary device matrix indicating between which ports of the device the optical signal can propagate within the device;
- selecting one of the ports of one of the devices as a first port;
- selecting one of the ports of another one of the devices as a second port; and
- determining one or more optical paths for the optical signal from the first port to the second port in function of the nets and in function of the binary device matrices of each of the devices comprised between the first port and the second port.

With the computer-implemented method according to the present disclosure, it becomes possible to determine how an optical signal propagates between two distinctive ports in a design of an integrated circuit. In other words, it becomes possible to determine one or more possible optical routes which can be followed by the optical signal between a first port and a second port in the design. This way, the computer-implemented method according to the present disclosure permits the determination and the anticipation of one or more optical paths which could be followed by light between the first port and the second port of the integrated circuit if the design of the integrated circuit were to be manufactured. In other words, the computer-implemented method according to the present disclosure permits the determination and the anticipation of one or more physical paths which could be followed by light between the first port and the second port of the integrated circuit if the design of the integrated circuit were to be manufactured. As will be described in further details below, establishing or simulating in an accurate manner how light is going to travel in a physical layout of a design is very valuable information for a designer or a user of a design, especially for somewhat more complex integrated circuits comprising for example tens or hundreds orthousands devices, and of course depending on potential processing variations. The identified optical paths may for example be rendered to be graphically displayed. This provides visual information to a designer and/or a user of the design on the routes along which light will travel once the integrated circuit is manufactured in an intuitive and simple manner. For example, it allows the designer and/or the user of the design to verify and/or debug a design before relying on the design for the generation of a physical layout of the IC.

With the computer-implemented method according to the present disclosure, graph theory may be used. The computer-implemented method according to the present disclosure uses the binary device matrices for each of the devices of the design of the integrated circuit to help simplifying a connectivity graph of the design and help removing possible paths found by one or more graph theory path algorithms. The computer-implemented method according to the present disclosure involves the automatic extraction of each scattering parameter, also referred to as S-parameter, for each device in the design. In the context of the present disclosure, a scattering parameter refers to an element in a mathematical matrix describing the behavior of an photonic device or network or circuit when it is being stimulated by an optical signal. With the computer-implemented method according to the present disclosure, a binary device matrix is determined for each of the devices of the design. The computer-implemented method according to the present disclosure further involves the extraction of one or more optical paths taking into account the binary device matrices of each of the devices of the design. In other words, the computer-implemented method according to the present disclosure defines one or more valid pathways within each device and between devices. This definition can be done manually by a designer or a user of the design. Alternatively, this definition can be automated based on the S-parameters of each device.

The computer-implemented method according to the present disclosure is useful in for example debugging a design. The designer or a user of the design can identify and intuitively understand how an optical signal propagates between two ports of a design, and the designer or a user of the design can easily recognize expected or unexpected obstacles for the optical signal, and/or expected or unexpected leakage of the optical signal. This allows improving the design to meet the technical requirements for the IC better. Additionally, the computer-implemented method according to the present disclosure makes it possible to verify a design. For example, a designer or a user of a design initially expects an optical signal to follow a first optical path in the design. With the computer-implemented method according to the present disclosure, the designer or the user can identify leakage of the optical signal to other optical paths than the first optical path, wherein leakage to the other optical paths is non-desired. By improving the design, leakage of the optical signal to other optical paths than the first path may be minimized or even avoided, thereby greatly improving the quality and the reliability of the design.

In the context of the present disclosure, the design of the integrated circuit may further comprise a direction of propagation for the optical signals within the design from the first port to the second port. For example, by selecting one of the ports of one of the devices as a first port, and one of the ports of another one of the devices as a second port, the computer-implemented method according to the present disclosure defines a direction of propagation for the optical signals which start propagating at the first port and which propagate towards the second port. The optical signals may encounter one or more reflections and/or leakage and travel back in a direction opposite to the initial direction of propagation. Not all optical signals might reach the second port when starting from the first port and when propagating along the direction of propagation towards the second port. The determination of one or more optical paths for an optical signal from the first port to the second port happens in function of the nets and the binary device matrices of each of the devices comprised between the first port and the second port and according to the direction of propagation. It is clear that the propagation of at least a fraction of the light wave of the optical signal is bidirectional in the design, in other words, from the selected port to any other port of the device and from any port of the design to the selected port.

In the context of the present disclosure, each device comprises one or more ports, wherein the ports comprise one or more input ports and/or one or more output ports. Ports are locations on the layout of the design where connections between devices are made. Each port has a name and a location in the design. A port is for example an optical port for the connection of for example optical waveguides or fibers. Alternatively, a port is for example an electrical port for the connection with for example electrical wires. Each input port is configured to receive for example one or more optical signals, sequentially or substantially simultaneously, wherein the optical signals are later on referred to as received optical signals. Each output port is configured to transmit for example one or more optical signals, sequentially or substantially simultaneously, wherein the transmitted optical signals correspond to the received optical signals having being transmitted through or processed by or having experienced optical processing within the respective device. Additionally, an input port may act as an output port when for example the input port receives an optical signal, and wherein the device is for example a reflector. In this event, the input port of the device transmits the reflected optical signal back out of the device, thereby acting as an output port for the device. Similarly, an output port may act as an input port when for example the output port transmits an optical signal, and wherein the optical signal is transmitted to another device which for example comprises a reflector. In this event, the output port of the device receives the reflected optical signal back into the device, thereby acting as an input port for the device.

In the context of the present disclosure, any port of any device may be selected as the first port and any port of any other device different from the first port may be selected as a second port.

In the context of the present disclosure, an optical signal comprises one or more light waves. An optical signal comprises discrete units called photons. An optical signal is an electromagnetic signal. It comprises an electric field and a magnetic field that are orthogonal to each other. In other words, an optical signal comprises electromagnetic energy waves, or EM radiation. The EM spectrum includes RF, light, X-rays, and gamma rays. The optical signals in the EM spectrum comprise oscillating electric fields and magnetic fields that are orthogonal to one another, traveling in a particular direction.

In the context of the present disclosure, an optical path corresponds to an optical route passing through one or more devices of a design comprised between the first port and the second port, wherein the optical route is followed by an optical signal. In other words, an optical signal propagates or flows or follows a path from one device to another and through one or more devices along an optical path comprised between the first port and the second port.

In the context of the present disclosure, a binary device matrix of a device comprises rows corresponding to all the input ports and all the output ports of the device, and further comprises columns corresponding to all the input ports and all the output ports of the device. A binary device matrix uses a number system based only on the numerals 0 and 1. A binary device matrix of a device indicates if an optical signal can propagate from any input port or output port of the device to any input port or output port of the same device. In other words, a binary device matrix indicates the transmission possibilities for an optical signal between any two ports of the device.

When a binary device matrix indicates 0 between for example an input port and an output port, it can be understood that an optical signal cannot propagate between from the input port to the output port. When a binary device matrix indicates 0 between for example an input port and another input port, it can be understood that an optical signal cannot propagate between from the input port to the other input port. When a binary device matrix indicates 0 between for example an output port and an input port, it can be understood that an optical signal cannot propagate between from the output port to the input port. When a binary device matrix indicates 0 between for example an output port and another output port, it can be understood that an optical signal cannot propagate between from the output port to the other output port. When a binary device matrix indicates 1 between for example an input port and an output port, it can be understood that an optical signal can propagate between from the input port to the output port. When a binary device matrix indicates 1 between for example an input port and another input port, it can be understood that an optical signal can propagate between from the input port to the other input port. When a binary device matrix indicates 1 between for example an output port and an input port, it can be understood that an optical signal can propagate between from the output port to the input port. When a binary device matrix indicates 1 between for example an output port and another output port, it can be understood that an optical signal can propagate between from the output port to the other output port.

In the context of the present disclosure, a net is a connection or a link between two devices. For example, a net can be a connection between two waveguides, while each waveguide is understood in the context of the present invention as a device.

In the context of the present invention, electronic design automation, also referred to as electronic computer-aided design or ECAD, refers to a category of software tools or computer-implemented tools for designing electronic systems such as for example integrated circuits and/or printed circuit boards. The tools work together in a design flow that chip designers use to design and analyse entire semiconductor chips. EDA tools focus for example on one or more of the following: the design of integrated circuits, simulations of the integrated circuits such as for example electrical simulations and/or electromagnetic simulations, analysis and verifications, manufacturing preparations, functional safety, etc. The term "automation" refers to the ability for end-users to augment, customize, and drive the capabilities of electronic and photonic design and verification tools by means of a scripting language and associated support utilities. The term "automation" further refers to the ability for end-users to automate tasks by means of computer algorithms instead of the user having to execute the same task by hand. The benefits are not only speed but most importantly reproducibility by removing human error. There are a wide variety of programming languages available for electronic design automation, such as for example traditional C and its object-oriented offspring, C++, Python, TCL, Cadence SKILL^{®}, SystemC, VHDL, verilog, Java, etc.

In the context of the present invention, an integrated circuit or monolithic integrated circuit, also referred to as an IC, a chip, or a microchip, is a set of electronic circuits and/or photonics circuits and/or microelectromechanical circuits and/or fluidic devices, on one small flat piece of semiconductor material that is for example silicon. The integration of large numbers of small electronic, photonic, MEMs components such as for example transistors and/or waveguides, into a small chip results in circuits that are orders of magnitude smaller, faster, and less expensive than those constructed of discrete components.

In the context of the present invention, a fluidic device corresponds to a device along which water may propagate.

A photonic integrated circuit or integrated optical circuit is a device that integrates multiple photonic functions and as such is similar to an electronic integrated circuit. A photonics device is any basic discrete device or physical entity in a photonics system used to affect photons or their associated fields. The major difference between the two is that a photonic integrated circuit provides functions for information signals imposed on optical wavelengths for example comprised in the visible spectrum or near infrared 850 nm-1650 nm. One example of material platform for photonic integrated circuits is indium phosphide, which allows for the integration of various optically active and passive functions on the same chip. Examples of photonic integrated circuits comprise two-section distributed Bragg reflector lasers, monolithic tunable lasers, widely tunable lasers, externally modulated lasers and transmitters, integrated receivers, etc. Alternatively, for example, silicon can, even though it is an indirect bandgap material, still be used to manufacture photonic integrated circuits.

According to example embodiments, each binary device matrix is derived from a scattering matrix of the respective device.

In the context of the present disclosure, a scattering matrix of a device comprises rows corresponding to all the input ports and all the output ports of the device, and further comprises columns corresponding to all the input ports and all the output ports of the device. A scattering matrix uses a number system not only based on the numerals 0 and 1. A scattering matrix is complex-valued with a magnitude comprised between 0 and 1. A scattering matrix of a device indicates how much of an optical signal can propagate from any input port or output port of the device to any input port or output port of the same device. In other words, a scattering matrix indicates the transmission possibilities and quantifies the optical signal strength of the transmission of an optical signal between any two ports of the device.

According to example embodiments, each binary device matrix comprises information indicative whether the optical signal can propagate from one of the ports of the device to another one of the ports of the device according to a predetermined function.

Each binary device matrix is derived from a scattering matrix of the respective device onto which one or more predetermined functions are applied for a particular wavelength. In other words, a heuristic is used to define a binary device matrix from a scattering matrix for each of the devices. A predetermined function can for example be defined for each port-to-port combination within a device. A predetermined function is for example a threshold. A predetermined function can for example be generic for all the devices of the design. Alternatively, a predetermined function can be defined for each of the devices of the design. For example, in the scattering matrix of a device, if a strength of the transmission between a port of a device and another port of the same device complies with the requirements of a predetermined function, a binary device matrix generated from the scattering matrix will be generated for the device and will indicate 1 with respect to the transmission between the corresponding port of the device and the other corresponding port of the same device. For example, in the scattering matrix of a device, if a strength of the transmission between a port of a device and another port of the same device does not comply with the requirements of a predetermined function, a binary device matrix generated from the scattering matrix will be generated for the device and will indicate 0 with respect to the transmission between the corresponding port of the device and the other corresponding port of the same device. For example, in the scattering matrix of a device, if a strength of the transmission between a port of a device and another port of the same device is above a predetermined threshold, a binary device matrix generated from the scattering matrix will be generated for the device and will indicate 1 with respect to the transmission between the corresponding port of the device and the other corresponding port of the same device. For example, in the scattering matrix of a device, if a strength of the transmission between a port of a device and another port of the same device is below a predetermined threshold, a binary device matrix generated from the scattering matrix will be generated for the device and will indicate 0 with respect to the transmission between the corresponding port of the device and the other corresponding port of the same device.

According to example embodiments, each binary device matrix comprises information indicative whether the optical signal can or cannot propagate from one of the ports of the device to another one of the ports of the device according to a predetermined function.

According to example embodiments, wherein each scattering matrix is environment-dependent, and wherein each binary device matrix can be environment-dependent.

For example, each scattering matrix is wavelength- and/or frequency- and/or temperature- dependent, and wherein each binary device matrix can be wavelength- and/or frequency- and/or temperature- dependent. The environment can be understood as the wavelength, the frequency, the temperature, or any other suitable globally defined property such as for example processing tolerances.

This way, when relying on binary device matrix, a dependence upon wavelength and/or frequency and/or temperature can be mediated or attenuated, for example a value of a binary device matrix can change from 0 to 1 or 1 to 0, with respect to the dependence of the corresponding scattering matrix upon wavelength and/or frequency and/or temperature. This makes the determination of the optical paths more accurate and reliable.

According to example embodiments, each binary device matrix further comprises information indicative whether the optical signal can or cannot propagate from one of the ports of the device to another one of the ports of the device for each optical mode comprised in the optical signal.

This way, a distinction can be made for the different optical modes within the optical signal. For example, one or more optical paths can be determined for one optical mode of the optical signal, while one or more optical paths different from the previous optical paths can be determined for another optical mode of the optical signal.

According to example embodiments, each scattering matrix of each device comprises information indicative for how much of the optical signal propagates from one of the ports of the device to another one of the ports of the device per wavelength or frequency comprised in the optical signal and/or for each optical mode comprised in the optical signal.

According to example embodiments, the step of determining one or more optical paths for the optical signal comprises the steps of:
- determining all possible paths for the optical signal from the first port to the second port and according to the binary device matrices of each of the devices and the nets between the devices; and
- selecting one or more optical paths out of the possible paths along which propagation of the optical signal is possible according to the binary device matrices of each of the devices comprised between the first port and the second port.

This way, a selection of the possible paths results in the determination of the optical paths for the optical signal. Alternatively, if existing, the computer-implemented method further comprises the step of removing one or more of the possible paths along which a propagation of the optical signal is not possible according to the binary device matrix of each of the devices comprised between the first port and the second port.

According to example embodiments, each of the optical paths comprises one or more of the nets.

This way, an optical path comprises the devices and further comprises the connections or the links between the corresponding devices.

According to example embodiments, the method further comprises the steps of:
- determining a binary device matrix for each device of a plurality of available devices comprising the devices of the design of the integrated circuit; and
- storing the binary device matrices of the available devices in a database;
and wherein, upon receipt of the design of the integrated circuit, the step of receiving a binary device matrix for the devices of the design of the integrated circuit corresponds to retrieving the binary device matrices of the devices of the design of the integrated circuit from the database.

This way, all the binary device matrices are determined beforehand and are available immediately upon request. The binary device matrices may be stored in a database, such as for example a library, and are linked to the respective devices. Determining the binary device matrices upfront allows to save processing power and processing time when a designer and/or a user of the design requests the determination of the optical paths. In other words, the time spent for calculating all the binary device matrices is spent before the designer and/or the user requests the determination of the optical paths, thereby speeding the process of determining the optical paths.

According to example embodiments, upon receipt of the design of the integrated circuit, the step of receiving a binary device matrix for each of the devices of the design of the integrated circuit corresponds to determining a binary device matrix for each of the devices of the design of the integrated circuit.

This way, a binary device matrix may be determined on the spot by the method according to the present disclosure. For example, when a new device is added to the design, a new binary device matrix must be determined for the device. This brings flexibility and improves the reactivity of the method to a more personalized design experience, thereby improving the user experience.

According to example embodiments, the method further comprises the steps of:
- generating a representation of the design of the integrated circuit incorporating the one or more optical paths; and
- displaying the representation of the design of the integrated circuit in a user client.

The representation of the design of the integrated circuit may be displayed to a browser. This way, graphically displaying the representation of the design in a user client remains independent from the nature and the version of the operating systems of different user clients, and independent from the applications and from the version of the applications running on for example application servers. For example, the representation of the design of the integrated circuit may be streamed to a user client in a browser, thereby keeping the implementation of the method according to the present disclosure lightweight. This simple and light implementation at the side of the user client minimizes the configuration of the user client. For example, the user client may comprise a Graphical User Interface. The generator of the representation of the design and the user client and the unit displaying the representation of the design are for example comprised in a system according to a second example aspect of the present invention.

In the context of the present disclosure, a user client may be a Command-Line Interface (CLI) Client, which is a text-based interface that allows users to interact with a system or service using commands. Examples include terminal emulators like Command Prompt on Windows, Terminal on macOS, and various Unix/Linux shells like Bash. Alternatively, a user client may be a Graphical User Interface (GUI) Client, which is software with graphical interfaces that allow users to interact with a system or service using menus, buttons, and other visual elements. Examples include FTP clients like FileZilla, database management tools like phpMyAdmin, and version control clients like GitHub Desktop. Alternatively, a user client is an API Client, which is software applications or libraries that allow developers to interact with an API (Application Programming Interface) to access and manipulate data or services. Examples include Postman for testing REST APIs and cURL for making HTTP requests from the command line.

According to a second example aspect of the present invention, there is provided a system for determining one or more optical paths along which an optical signal propagates in a design of an integrated circuit, wherein the system comprises at least one processor and at least one memory including computer program code, the at least one memory and computer program code configured to, with the at least one processor, cause the system to perform:
- receiving a design of an integrated circuit comprising:
   ∘ a plurality of devices, each of the devices comprising ports;
   ∘ one or more nets, wherein each net couples one of the ports of one of the devices to one of the ports of another one of the devices;
- for each of the devices, receiving a binary device matrix indicating between which ports of the device the optical signal can propagate within the device;
- selecting one of the ports of one of the devices as a first port;
- selecting one of the ports of another one of the devices as a second port; and
- determining one or more optical paths for the optical signal from the first port to the second port in function of the nets and in function of the binary device matrices of each of the devices comprised between the first port and the second port.

With the system according to the present disclosure, it becomes possible to determine how an optical signal propagates between two distinctive ports in a design of an integrated circuit. In other words, it becomes possible to determine one or more possible optical routes which can be followed by the optical signal between a first port and a second port in the design. This way, the system according to the present disclosure permits the determination and the anticipation of one or more optical paths which could be followed by light between the first port and the second port of the integrated circuit if the design of the integrated circuit were to be manufactured. In other words, the system according to the present disclosure permits the determination and the anticipation of one or more physical paths which could be followed by light between the first port and the second port of the integrated circuit if the design of the integrated circuit were to be manufactured. Establishing in an accurate manner how light is going to travel in a design is very valuable information for a designer or a user of a design, especially for somewhat more complex integrated circuits comprising for example tens or hundreds or thousands devices. The identified optical paths may for example be rendered to be graphically displayed. This provides visual information to a designer and/or a user of the design on the routes along which light will travel once the integrated circuit is manufactured in an intuitive and simple manner.

The system according to the present disclosure is useful in for example debugging a design. The designer or a user of the design can identify and intuitively understand how an optical signal propagates between two ports of a design, and the designer or a user of the design can easily recognize expected or unexpected obstacles for the optical signal, and/or expected or unexpected leakage of the optical signal. This allows improving the design to meet the technical requirements for the IC better. Additionally, the system according to the present disclosure makes it possible to verify a design. For example, a designer or a user of a design initially expects an optical signal to follow a first optical path in the design. With the system according to the present disclosure, the designer or the user can identify leakage of the optical signal to other optical paths than the first optical path, wherein leakage to the other optical paths is non-desired. By improving the design, leakage of the optical signal to other optical paths than the first path may be minimized or even avoided, thereby greatly improving the quality and the reliability of the design.

There is provided a system comprising:
- a processor;
- a memory;
- an optical paths determination module executable by the processor to:
   ∘ receive a design of an integrated circuit comprising:
      ▪ a plurality of devices, each of the devices comprising ports;
      ▪ one or more nets, wherein each net couples one of the ports of one of the devices to one of the ports of another one of the devices;
   ∘ for each of the devices, receive a binary device matrix indicating between which ports of the device the optical signal can propagate within the device;
   ∘ select one of the ports of one of the devices as a first port;
   ∘ select one of the ports of another one of the devices as a second port; and
   ∘ determine one or more optical paths for the optical signal from the first port to the second port in function of the nets and in function of the binary device matrices of each of the devices comprised between the first port and the second port.

The memory for example is for example configured to store the binary device matrices of the devices.

According to a third example aspect of the present invention, there is provided a computer program product comprising computer-executable instructions for causing a system to perform at least the following:
- receiving a design of an integrated circuit comprising:
   ∘ a plurality of devices, each of the devices comprising ports;
   ∘ one or more nets, wherein each net couples one of the ports of one of the devices to one of the ports of another one of the devices;
- for each of the devices, receiving a binary device matrix indicating between which ports of the device the optical signal can propagate within the device;
- selecting one of the ports of one of the devices as a first port;
- selecting one of the ports of another one of the devices as a second port; and
- determining one or more optical paths for the optical signal from the first port to the second port in function of the nets and in function of the binary device matrices of each of the devices comprised between the first port and the second port.

According to a fourth example aspect of the present invention, there is provided a computer readable storage medium comprising computer-executable instructions for performing the following steps when the program is run on a computer:
- receiving a design of an integrated circuit comprising:
   ∘ a plurality of devices, each of the devices comprising ports;
   ∘ one or more nets, wherein each net couples one of the ports of one of the devices to one of the ports of another one of the devices;
- for each of the devices, receiving a binary device matrix indicating between which ports of the device the optical signal can propagate within the device;
- selecting one of the ports of one of the devices as a first port;
- selecting one of the ports of another one of the devices as a second port; and
- determining one or more optical paths for the optical signal from the first port to the second port in function of the nets and in function of the binary device matrices of each of the devices comprised between the first port and the second port.

### Brief Description of the Drawings

Some example embodiments will now be described with reference to the accompanying drawings.
Fig. 1 depicts an example embodiment of an optical path for an optical signal, determined by an example embodiment of a method according to the present disclosure.
Fig. 2 depicts an example embodiment of an optical path for an optical signal, determined by an example embodiment of a method according to the present disclosure.
Fig. 3 depicts an example embodiment of an optical path for an optical signal, determined by an example embodiment of a method according to the present disclosure.
Fig. 4A depicts an example embodiment of a directional coupler. Fig. 4B depicts an example embodiment of a scattering matrix of a directional coupler according to the present disclosure. Fig. 4C depicts an example embodiment of a binary device matrix of a directional coupler according to the present disclosure. Fig. 4D depicts an example embodiment of a binary matrix of a directional coupler according to the present disclosure.
Fig. 5 shows an example embodiment of a suitable computing system for performing one or several steps in embodiments of the invention.

### Detailed Description of Embodiment(s)

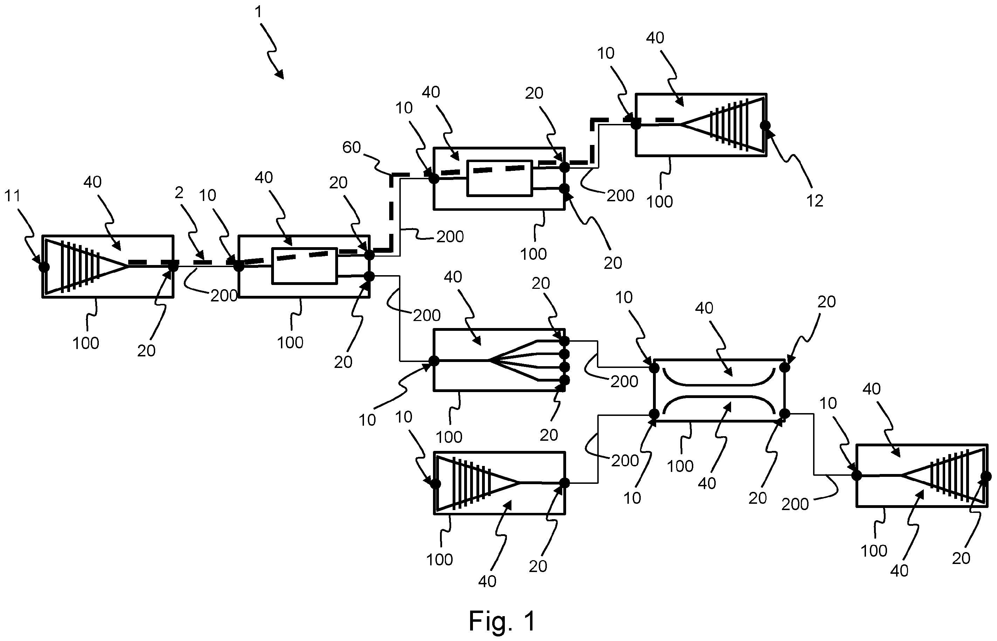

Fig. 1 illustrates an example embodiment of an optical path 60 for an optical signal 2, determined by an example embodiment of a method according to the present disclosure. The method according to the present disclosure is used for determining one or more optical paths 60 along which an optical signal 2 propagates in a design 1 of an integrated circuit. The method comprises the steps of receiving a design 1 of an integrated circuit, wherein the design 1 comprises eight devices 100, each of the devices 100 comprising ports 10;20. The devices 100 can be grating couplers, directional couplers, splitters, MMIs, AWGs, waveguides, reflectors, couplers, any other photonic device. The design 1 further comprises a plurality of nets 200, wherein each net 200 couples one of the ports 10 or 20 of one of the devices 100 to one of the ports 10 or 20 of another one of the devices 100. For each of the devices 100, a binary device matrix 40 is received and indicates between which ports of the device 100 the optical signal 2 can propagate within the device 100. One of the ports 10 has been selected as a first port 11. Another one of the ports 20 has been selected as a second port 12. One or more optical paths 60 for the optical signal 2 from the first port 11 to the second port 12 are determined in function of the nets 200 and in function of the binary device matrices 40 of each of the devices comprised between the first port 11 and the second port 12. On Fig. 1, one optical path 60 is determined between the first port 11 and the second port 12. The optical path 60 comprises a plurality of the nets 200 between the first port 11 and the second port 12.

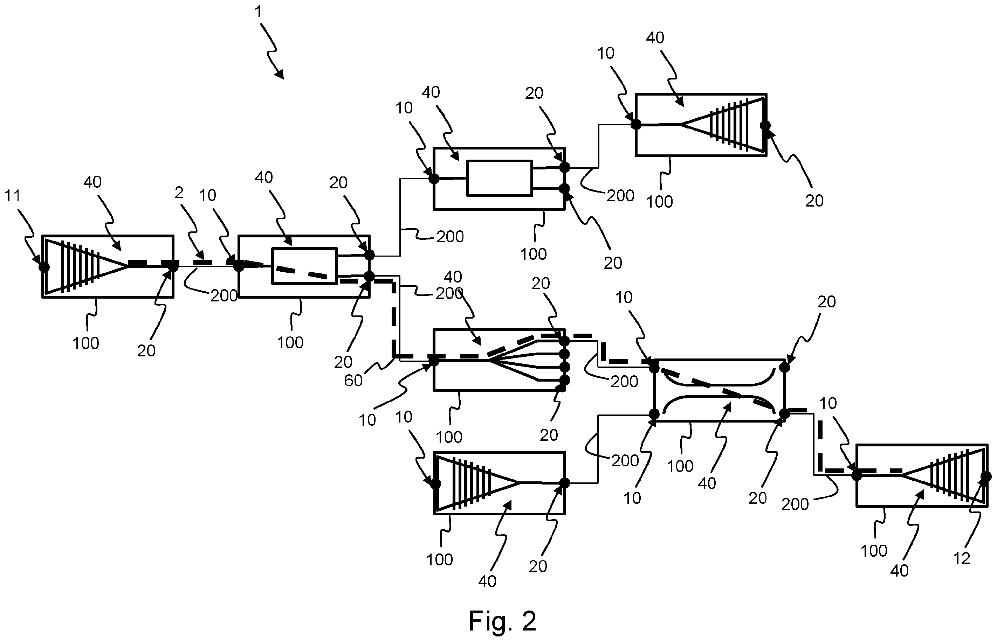

Fig. 2 illustrates an example embodiment of an optical path 60 for an optical signal 2, determined by an example embodiment of a method according to the present disclosure. Components having identical references as in Fig. 1 fulfill the same function. The method according to the present disclosure is used for determining one or more optical paths 60 along which an optical signal 2 propagates in a design 1 of an integrated circuit. The method comprises the steps of receiving a design 1 of an integrated circuit, wherein the design 1 comprises eight devices 100, each of the devices 100 comprising ports 10;20. The design 1 further comprises a plurality of nets 200, wherein each net 200 couples one of the ports 10 or 20 of one of the devices 100 to one of the ports 10 or 20 of another one of the devices 100. For each of the devices 100, a binary device matrix 40 is received and indicates between which ports of the device 100 the optical signal 2 can propagate within the device 100. One of the ports 10 has been selected as a first port 11. Another one of the ports 20 has been selected as a second port 12. One or more optical paths 60 for the optical signal 2 from the first port 11 to the second port 12 are determined in function of the nets 200 and in function of the binary device matrices 40 of each of the devices comprised between the first port 11 and the second port 12. On Fig. 2, one optical path 60 is determined between the first port 11 and the second port 12. The optical path 60 comprises a plurality of the nets 200 between the first port 11 and the second port 12.

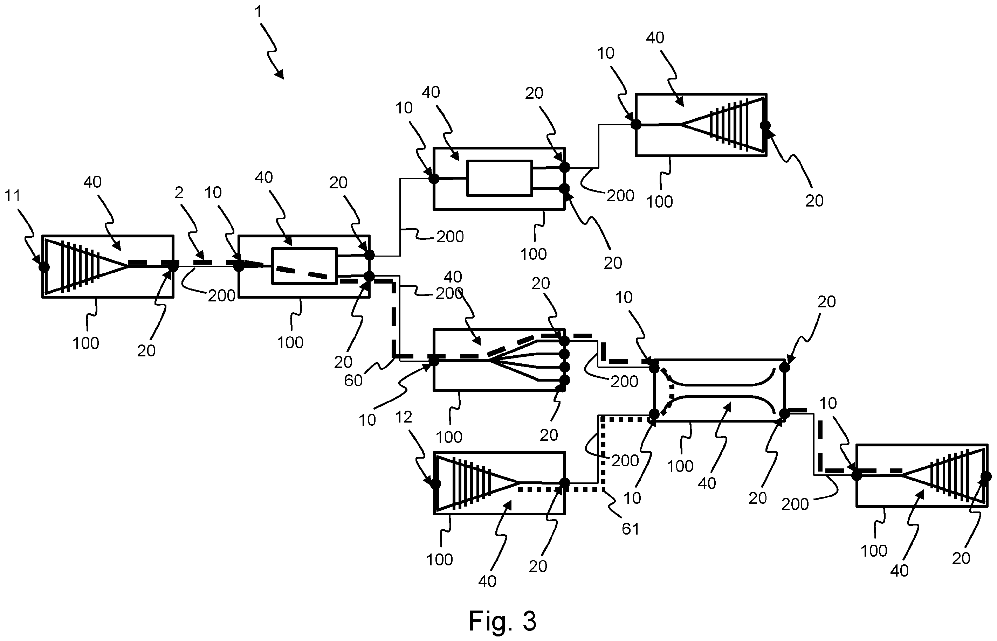

Fig. 3 illustrates an example embodiment of an optical path 60 for an optical signal 2, determined by an example embodiment of a method according to the present disclosure. Components having identical references as in Fig. 1 and Fig. 2 fulfill the same function. The method according to the present disclosure is used for determining one or more optical paths 60 along which an optical signal 2 propagates in a design 1 of an integrated circuit. The method comprises the steps of receiving a design 1 of an integrated circuit, wherein the design 1 comprises eight devices 100, each of the devices 100 comprising ports 10;20. The design 1 further comprises a plurality of nets 200, wherein each net 200 couples one of the ports 10 or 20 of one of the devices 100 to one of the ports 10 or 20 of another one of the devices 100. For each of the devices 100, a binary device matrix 40 is received and indicates between which ports of the device 100 the optical signal 2 can propagate within the device 100. One of the ports 10 has been selected as a first port 11. Another one of the ports 20 has been selected as a second port 12. One or more optical paths 60 for the optical signal 2 from the first port 11 to the second port 12 are determined in function of the nets 200 and in function of the binary device matrices 40 of each of the devices comprised between the first port 11 and the second port 12. On Fig. 3, one optical path 60 is determined between the first port 11 and the second port 12. The optical path 60 comprises a plurality of the nets 200 between the first port 11 and the second port 12. As visible on Fig. 3, the optical path 61 is a parasitic optical path along which the optical signal 2 cannot propagate. Indeed, the binary device matrix 40 of the directional coupler 100 indicates that transmission between the input port 10 in1 of the directional coupler and the input port 10 in2 of the same directional coupler is impossible. The optical path 61 is therefore not selected as a valid optical path for the optical signal 2 and will not be displayed if a user requests a graphical rendering of the optical paths 60. In other words, when the first port 11 is selected and when the second port 12 is selected, an optical path 60 for the optical signal 2 will stop at the input port 10 in1 of the directional coupler 100.

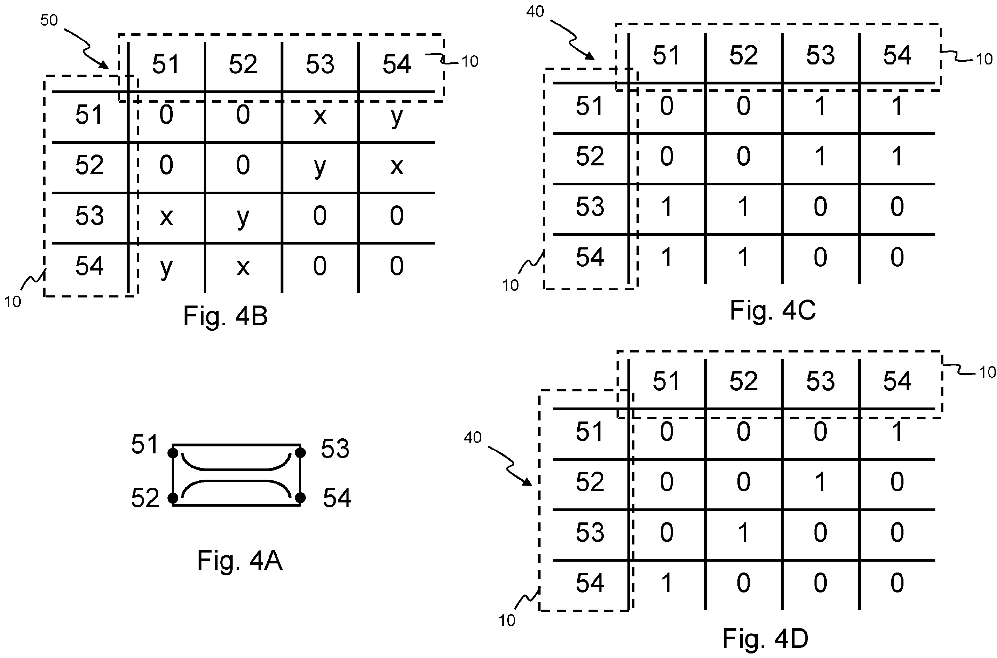

Fig. 4A schematically illustrates an example embodiment of a directional coupler comprising two input ports 10 labelled 51;52 and two output ports 10 labelled 53;54. Fig. 4B schematically illustrates an example embodiment of a scattering matrix 50 of the directional coupler of Fig. 4A, indicating how much light x;y goes from one port 10 to another port 10 for a particular wavelength. Fig. 4C schematically illustrates an example embodiment of a possible binary device matrix for the directional coupler of Fig. 4A derived from the scattering matrix 50 of Fig. 4B, indicating whether light can propagate from one port 10 to another 10. Fig. 4D schematically illustrates an example embodiment of another possible binary device matrix for the directional coupler of Fig. 4A derived from the scattering matrix 50 of Fig. 4B, indicating whether light can propagate from one port 10 to another port 10.

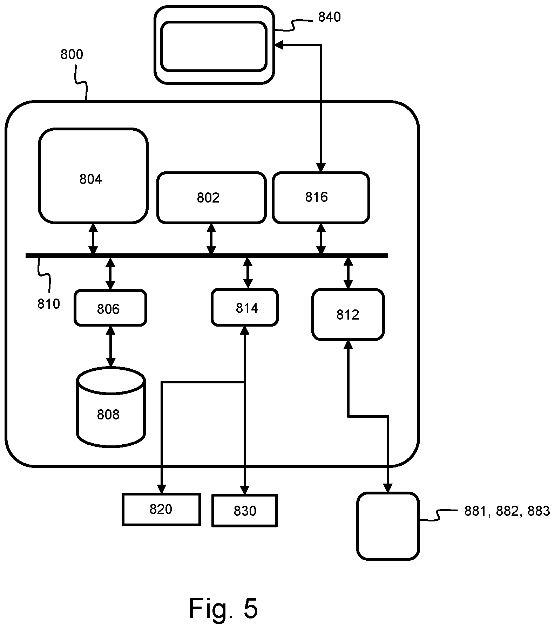

Fig. 5 shows a suitable computing system 800 enabling to implement embodiments of the system. Computing system 800 may in general be formed as a suitable general-purpose computer and comprise a bus 810, a processor 802, a local memory 804, one or more optional input interfaces 814, one or more optional output interfaces 816, a communication interface 812, a storage element interface 806, and one or more storage elements 808. Bus 810 may comprise one or more conductors that permit communication among the components of the computing system 800. Processor 802 may include any type of conventional processor or microprocessor that interprets and executes programming instructions. Local memory 804 may include a random-access memory (RAM) or another type of dynamic storage device that stores information and instructions for execution by processor 802 and/or a read only memory (ROM) or another type of static storage device that stores static information and instructions for use by processor 802. Input interface 814 may comprise one or more conventional mechanisms that permit an operator or user to input information to the computing device 800, such as a keyboard 820, a mouse 830, a pen, voice recognition and/or biometric mechanisms, a camera, etc. Output interface 816 may comprise one or more conventional mechanisms that output information to the operator or user, such as a display 840, etc. Communication interface 812 may comprise any transceiver-like mechanism such as for example one or more Ethernet interfaces that enables computing system 800 to communicate with other devices and/or systems, for example with other computing devices 881, 882, 883. The communication interface 812 of computing system 800 may be connected to such another computing system by means of a local area network (LAN) or a wide area network (WAN) such as for example the internet. Storage element interface 806 may comprise a storage interface such as for example a Serial Advanced Technology Attachment (SATA) interface or a Small Computer System Interface (SCSI) for connecting bus 810 to one or more storage elements 808, such as one or more local disks, for example SATA disk drives, and control the reading and writing of data to and/or from these storage elements 808. Although the storage element(s) 808 above is/are described as a local disk, in general any other suitable computer-readable media such as a removable magnetic disk, optical storage media such as a CD or DVD, -ROM disk, solid state drives, flash memory cards, ... could be used. It is noticed that the entire computer-implemented method according to the present invention can be executed centralized, e.g. on a server in a management center or in a cloud system, or it can be partially executed on a remote electronic device, e.g. worn by the user, and partially on a central server. Computing system 800 could thus correspond to the system available centrally or the processing system available in the electronic device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

**1.** A computer-implemented method for determining one or more optical paths (60) along which an optical signal (2) propagates in a design (1) of an integrated circuit, the method comprising the steps of:
- receiving a design (1) of an integrated circuit comprising:
∘ a plurality of devices (100), each of the devices (100) comprising ports (10);
∘ one or more nets (200), wherein each net (200) couples one of the ports (10) of one of the devices (100) to one of the ports (10) of another one of the devices (100);
- for each of the devices (100), receiving a binary device matrix (40) indicating between which ports (10) of the device (100) the optical signal (2) can propagate within the device (100);
- selecting one of the ports (10) of one of the devices (100) as a first port (11);
- selecting one of the ports (10) of another one of the devices (100) as a second port (12); and
- determining one or more optical paths (60) for the optical signal (2) from the first port (11) to the second port (12) in function of the nets (200) and in function of the binary device matrices (40) of each of the devices (100) comprised between the first port (11) and the second port (12).

**2.** The method according to claim 1, wherein each binary device matrix (40) is derived from a scattering matrix of the respective device (100).

**3.** The method according to any of the preceding claims, wherein each binary device matrix (40) comprises information indicative whether the optical signal (2) can propagate from one of the ports (10) of the device (100) to another one of the ports (10) of the device (100) according to a predetermined function.

**4.** The method according to claim 1 or 2, wherein each binary device matrix (40) comprises information indicative whether the optical signal (2) cannot propagate from one of the ports (10) of the device (100) to another one of the ports (10) of the device (100) according to a predetermined function.

**5.** The method according to any of the preceding claims 2 to 4, wherein each scattering matrix is environment-dependent, and wherein each binary device matrix (40) can be environment-dependent.

**6.** The method according to any of the preceding claims, wherein each binary device matrix (40) further comprises information indicative whether the optical signal (2) can or cannot propagate from one of the ports (10) of the device (100) to another one of the ports (10) of the device (100) for each optical mode comprised in the optical signal (2).

**7.** The method according to claim 2, wherein each scattering matrix of each device (100) comprises information indicative for how much of the optical signal (2) propagates from one of the ports (10) of the device (100) to another one of the ports (10) of the device (100) per wavelength or frequency comprised in the optical signal (2) and/or for each optical mode comprised in the optical signal (2).

**8.** The method according to any of the preceding claims, wherein the step of determining one or more optical paths (60) for the optical signal (2) comprises the steps of:
- determining all possible paths (50) for the optical signal (2) from the first port (11) to the second port (12) and according to the binary device matrices (40) of each of the devices (100) and the nets (200) between the devices (100); and
- selecting one or more optical paths (60) out of the possible paths (50) along which propagation of the optical signal (2) is possible according to the binary device matrices (40) of each of the devices (100) comprised between the first port (11) and the second port (12).

**9.** The method according to any of the preceding claims, wherein each of the optical paths (60) comprises one or more of the nets (200).

**10.** The method according to any of the preceding claims, wherein the method further comprises the steps of:
- determining a binary device matrix (40) for each device of a plurality of available devices (600) comprising the devices (100) of the design (1) of the integrated circuit; and
- storing the binary device matrices (40) of the available devices (600) in a database; and wherein, upon receipt of the design (1) of the integrated circuit, the step of receiving a binary device matrix (40) for the devices (100) of the design (1) of the integrated circuit corresponds to retrieving the binary device matrices (40) of the devices (100) of the design (1) of the integrated circuit from the database.

**11.** The method according to any of the claims 1 to 9, wherein, upon receipt of the design (1) of the integrated circuit, the step of receiving a binary device matrix (40) for each of the devices (100) of the design (1) of the integrated circuit corresponds to determining a binary device matrix (40) for each of the devices (100) of the design (1) of the integrated circuit.

**12.** The method according to any of the preceding claims, wherein the method further comprises the steps of:
- generating a representation of the design (1) of the integrated circuit incorporating the one or more optical paths (60); and
- displaying the representation of the design (1) of the integrated circuit in a user client.

**13.** A system for determining one or more optical paths (60) along which an optical signal (2) propagates in a design (1) of an integrated circuit, wherein the system comprises at least one processor and at least one memory including computer program code, the at least one memory and computer program code configured to, with the at least one processor, cause the system to perform:
- receiving a design (1) of an integrated circuit comprising:
∘ a plurality of devices (100), each of the devices (100) comprising ports (10);
∘ one or more nets (200), wherein each net (200) couples one of the ports (10) of one of the devices (100) to one of the ports (10) of another one of the devices (100);
- for each of the devices (100), receiving a binary device matrix (40) indicating between which ports (10) of the device (100) the optical signal (2) can propagate within the device (100);
- selecting one of the ports (10) of one of the devices (100) as a first port (11);
- selecting one of the ports (10) of another one of the devices (100) as a second port (12); and
- determining one or more optical paths (60) for the optical signal (2) from the first port (11) to the second port (12) in function of the nets (200) and in function of the binary device matrices (40) of each of the devices (100) comprised between the first port (11) and the second port (12).

**13.** A computer program product comprising computer-executable instructions for causing a system to perform at least the following:
- receiving a design (1) of an integrated circuit comprising:
∘ a plurality of devices (100), each of the devices (100) comprising ports (10);
∘ one or more nets (200), wherein each net (200) couples one of the ports (10) of one of the devices (100) to one of the ports (10) of another one of the devices (100);
- for each of the devices (100), receiving a binary device matrix (40) indicating between which ports (10) of the device (100) the optical signal (2) can propagate within the device (100);
- selecting one of the ports (10) of one of the devices (100) as a first port (11);
- selecting one of the ports (10) of another one of the devices (100) as a second port (12); and
- determining one or more optical paths (60) for the optical signal (2) from the first port (11) to the second port (12) in function of the nets (200) and in function of the binary device matrices (40) of each of the devices (100) comprised between the first port (11) and the second port (12).

**14.** A computer readable storage medium comprising computer-executable instructions for performing the following steps when the program is run on a computer:
- receiving a design (1) of an integrated circuit comprising:
∘ a plurality of devices (100), each of the devices (100) comprising ports (10);
∘ one or more nets (200), wherein each net (200) couples one of the ports (10) of one of the devices (100) to one of the ports (10) of another one of the devices (100);
- for each of the devices (100), receiving a binary device matrix (40) indicating between which ports (10) of the device (100) the optical signal (2) can propagate within the device (100);
- selecting one of the ports (10) of one of the devices (100) as a first port (11);
- selecting one of the ports (10) of another one of the devices (100) as a second port (12); and
- determining one or more optical paths (60) for the optical signal (2) from the first port (11) to the second port (12) in function of the nets (200) and in function of the binary device matrices (40) of each of the devices (100) comprised between the first port (11) and the second port (12).
